(19) Europäisches Patentamt / European Patent Office / Office européen des brevets

(11) **EP 4 358 533 A1**

(12) **EUROPEAN PATENT APPLICATION**
published in accordance with Art. 153(4) EPC

(43) Date of publication:
**24.04.2024 Bulletin 2024/17**

(21) Application number: **22869702.5**

(22) Date of filing: **29.07.2022**

(51) International Patent Classification (IPC):
**H04N 25/67** (2023.01)   **G01J 1/42** (2006.01)
**G01J 1/02** (2006.01)

(52) Cooperative Patent Classification (CPC):
**G01J 1/02; G01J 1/42**

(86) International application number:
**PCT/JP2022/029355**

(87) International publication number:
**WO 2023/042554 (23.03.2023 Gazette 2023/12)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.09.2021 JP 2021150031**

(71) Applicant: **Hamamatsu Photonics K.K.**
**Hamamatsu-shi, Shizuoka 435-8558 (JP)**

(72) Inventors:
• **NAKAMOTO Katsuhiro**
  **Hamamatsu-shi, Shizuoka 435-8558 (JP)**
• **HOTAKA Hisaya**
  **Hamamatsu-shi, Shizuoka 435-8558 (JP)**

(74) Representative: **Grünecker Patent- und Rechtsanwälte**
**PartG mbB**
**Leopoldstraße 4**
**80802 München (DE)**

(54) **ESTIMATION METHOD, ESTIMATION PROGRAM, AND ESTIMATION DEVICE**

(57)    An estimation device for estimating a conversion factor which is a ratio between the number of photoelectrons generated from a pixel in response to inputting of light to the pixel and an electrical signal intensity output in response to the number of photoelectrons is provided. The estimation device includes: an acquisition unit configured to acquire a plurality of data groups including the electrical signal intensity for each of a plurality of pixels when light is input to the plurality of pixels; and a calculation unit configured to calculate the conversion factor for each of the plurality of pixels from the plurality of data groups based on a likelihood function indicating a likelihood of the conversion factor corresponding to the output electrical signal intensity.

*Fig.1*

## Description

### Technical Field

The present disclosure relates to an estimation method, an estimation program, and an estimation device.

### Background Art

For example, a photon counting device using a complementary metal oxide semiconductor (CMOS) image sensor is described in Patent Literature 1 and Patent Literature 2. In this device, when photons are input to a photoelectric conversion element, photoelectrons generated based on the number of input photons are accumulated as electric charges. The electric charges accumulated in the photoelectric conversion element are converted to a voltage which is amplified by an amplifier. A voltage output from the amplifier is converted to a digital value by an A/D converter. In the photon counting device, the number of photons in a pixel of the image sensor is determined based on the digital value output from the A/D converter.

A technique of measuring a gain in a CMOS image sensor is described in Non-Patent Literature 1. In this technique, a histogram for a counted value of photons for each pixel is generated, and a gain is calculated based on peak intervals of the histogram.

### Citation List

### Patent Literature

[Patent Literature 1] PCT International Publication No. WO2019/102636
[Patent Literature 2] PCT International Publication No. WO2019/102637
[Non-Patent Literature 1] Starkey, Dakota A., and Eric R. Fossum, "Determining conversion gain and read noise using a photon-counting histogram method for deep sub-electron read noise image sensors," IEEE Journal of the Electron Devices Society 4.3 (2016): 129-135

### Summary of Invention

### Technical Problem

When a gain (a conversion factor) is calculated based on peak intervals of a histogram, peaks in the histogram need to be able to be resolved. Accordingly, when it is intended to accurately calculate a gain, for example, data of 10000 frames or more is considered to be necessary.

An aspect of the present disclosure provides an estimation method that can reduce an amount of data required for estimating (calculating) a conversion factor.

### Solution to Problem

An estimation method according to an example is an estimation method of estimating a conversion factor which is a ratio between the number of photoelectrons generated from a pixel in response to inputting of light to the pixel and an electrical signal intensity output in response to the number of photoelectrons, the estimation method including: a step of acquiring a plurality of data groups including the electrical signal intensity for each of a plurality of pixels when light is input to the plurality of pixels; and a step of calculating the conversion factor for each of the plurality of pixels from the plurality of data groups based on a likelihood function indicating a likelihood of the conversion factor corresponding to the output electrical signal intensity.

An estimation program according to an example is an estimation program for estimating a conversion factor which is a ratio between the number of photoelectrons generated from a pixel in response to inputting of light to the pixel and an electrical signal intensity output in response to the number of photoelectrons, the estimation program causing a computer to perform: an acquisition process of acquiring a plurality of data groups including the electrical signal intensity for each of a plurality of pixels when light is input to the plurality of pixels; and a calculation process of calculating the conversion factor for each of the plurality of pixels from the plurality of data groups based on a likelihood function indicating a likelihood of the conversion factor corresponding to the output electrical signal intensity.

An estimation device according to an example is an estimation device for estimating a conversion factor which is a ratio between the number of photoelectrons generated from a pixel in response to inputting of light to the pixel and an electrical signal intensity output in response to the number of photoelectrons, the estimation device including: an acquisition unit configured to acquire a plurality of data groups including the electrical signal intensity for each of a plurality of pixels when light is input to the plurality of pixels; and a calculation unit configured to calculate the conversion factor for each of the plurality of pixels from the plurality of data groups based on a likelihood function indicating a likelihood of the conversion factor corresponding to the output electrical signal intensity.

In the estimation method, the estimation program, and the estimation device according to the examples, since a likelihood function is used to estimate a conversion factor, it is possible to reduce an amount of data required for estimating the conversion factor. For example, when each data group is image data reflecting an electrical signal intensity in each pixel, it is possible to reduce the number of frames required for estimating the conversion factor.

The likelihood function may be defined with reference to a probability density distribution of the electrical signal intensities. The probability density distribution of the electrical signal intensities may include a function of deriving an electrical signal intensity from the number of photoelectrons corresponding to a light intensity with the conversion factor as a parameter.

The probability density distribution of the electrical signal intensities may include a probability density distribution in consideration of reading noise in the plurality of pixels. It is possible to improve accuracy of the probability density distribution by considering the reading noise.

The probability density distribution of the electrical signal intensities may include a probability distribution of the number of photoelectrons. With this configuration, both when light with a fixed average photon number is applied and when an average photon number changes with the elapse of time, it is possible to accurately estimate the conversion factor.

When a probability distribution of the number of photoelectrons n is defined as $q_i(n)$, a function of determining an electrical signal intensity x in response to the number of photoelectrons n when the conversion factor is $\alpha$ is defined as $x=f(n; \alpha)$, and a probability density distribution of an electrical signal intensity x; in the i-th data group at the number of photoelectrons n is defined as $r(x;; n, \alpha, [f])$, $L(\alpha)$ which is the likelihood function may be expressed by:

[Formula 1]

$$L\left(\alpha\right) = \prod_i \sum_n q_i(n) r(x_i; n, \alpha, [f])$$

When an average photon number is defined as $\lambda$ and reading noise is defined as $\sigma$, the likelihood function may be expressed by:

[Formula 2]

$$L\left(\alpha\right) = \prod_i \sum_n \frac{e^{-\lambda}\lambda^n}{n!} \exp\left\{-\frac{(x_i - \alpha n)^2}{2\sigma^2}\right\}$$

When reading noise is defined as $\sigma$, the likelihood function may be expressed by:

[Formula 3]

$$L\left(\alpha\right) = \prod_i \sum_n \exp\left\{-\frac{(x_i - \alpha n)^2}{2\sigma^2}\right\}$$

When a degree of freedom v is defined as:

[Formula 4]

$$\nu = \frac{2\sigma^2}{\sigma^2 - 1}$$

,

r(x;; n, α, [f]) indicating the probability density distribution may be defined using a t-distribution of the degree of freedom v, and
the likelihood function may be expressed by:

[Formula 5]

$$L(\alpha) = \prod_i \sum_n \frac{e^{-\lambda}\lambda^n}{n!} \frac{\Gamma\left(\frac{\nu+1}{2}\right)}{\sqrt{\nu\pi}\,\Gamma\left(\frac{\nu}{2}\right)} \left\{1 + \frac{(x-\alpha n)^2}{\nu}\right\}^{-(\nu+1)/2}$$

**Advantageous Effects of Invention**

According to an aspect of the present disclosure, it is possible to provide an estimation method that can reduce an amount of data required for estimating a conversion factor.

**Brief Description of Drawings**

FIG. 1 is a diagram illustrating a configuration of a photon counting device according to an example.
FIG. 2 is a diagram illustrating a usage mode of a photon counting device according to an example.
FIG. 3 is a diagram illustrating a usage mode of a photon counting device according to an example.
FIG. 4 is a flowchart illustrating an estimation method.
FIG. 5 is a diagram illustrating a recording medium in which a program for the photon counting device according to the example is stored.
FIG. 6 is a diagram illustrating simulation results of digital values derived by the photon counting device according to the example in a histogram.
FIG. 7 is a diagram illustrating simulation results of photon numbers derived by the photon counting device according to the example in a histogram.
FIG. 8 is a diagram illustrating digital values derived by the photon counting device according to the example in a histogram.
FIG. 9 is a diagram illustrating correction values of digital values derived by the photon counting device according to the example in a histogram.
FIG. 10 is a diagram illustrating simulation results of digital values derived by a photon counting device according to another example in a histogram.

**Description of Embodiments**

Hereinafter, an embodiment will be specifically described with reference to the accompanying drawings. For the purpose of convenience, elements that are substantially the same will be referred to by the same reference signs and description thereof may be omitted. In the following description, a photon counting device is described, but an estimation device according to the present disclosure may be a photon counting device, may be a part of the photon counting device, or may be a system including a part or whole of the photon counting device. In the following description, photon counting includes both of counting the number of photoelectrons generated in each pixel of an image sensor and counting the number of photons in consideration of quantum efficiency (QE) of the image sensor.

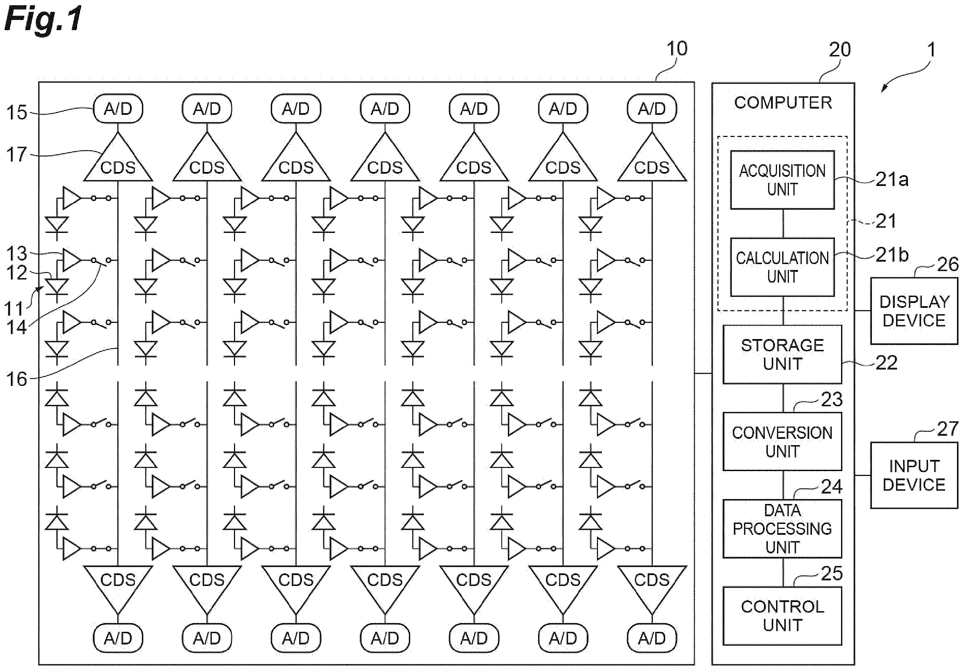

FIG. 1 is a diagram illustrating a configuration of a photon counting device according to an example. As illustrated in FIG. 1, a photon counting device according to an example includes a CMOS image sensor 10 which is a two-dimensional image sensor and a computer (a control device) 20 connected to the CMOS image sensor 10. The CMOS image sensor 10 includes a plurality of pixels 11 and A/D converters 15. The plurality of pixels 11 are two-dimensionally arranged. That is, the plurality of pixels 11 are arranged in a row direction and a column direction. Each pixel 11 includes a photodiode (a photoelectric conversion element) 12 and an amplifier 13. The photodiode 12 accumulates electrons (photoelectrons) generated in response to inputting of photons as electric charges. The amplifier 13 converts the electric charges accumulated in the photodiode 12 to a voltage and amplifies the converted voltage. The amplified voltage is transferred to a vertical signal line 16 for each line (for each row) by switching a selection switch 14 of the corresponding pixel 11. A correlated double sampling (CDS) circuit 17 is provided in each vertical signal line 16. The CDS circuit 17 removes uneven noise between pixels and temporarily stores the transferred voltage.

Each A/D converter 15 converts the voltage output from the amplifier 13 of each of the plurality of pixels 11 to a digital value (a pixel value). The A/D converter 15 may be provided in each pixel 11. In this embodiment, the A/D converter 15 converts the voltage stored in the CDS circuit 17 to a digital value. The converted digital values are output to the computer 20. For example, the digital values may be sent to a horizontal signal line which is not illustrated by switching for column selection and output to the computer 20. In this way, the CMOS image sensor 10 outputs a digital value corresponding to the number of input photons (the number of generated photoelectrons) to the computer 20 when photons are input to each pixel 11. When the voltage amplified by the amplifier 13 is read, reading noise which is random noise is generated in the amplifier 13.

The computer 20 physically includes a storage device such as a RAM or a ROM, a processor (an arithmetic operation circuit) such as a CPU or a GPU, and a communication interface. For example, a personal computer, a cloud server, a smart device (such as a smartphone or a tablet terminal), a microcomputer, or a field-programmable gate array (FPGA) can be used as the computer 20. The computer 20 serves as an estimation unit 21, a storage unit 22, a conversion unit 23, a data processing unit 24, and a control unit 25 by causing the processor of a computer system to execute a program stored in the storage device. The computer 20 may be provided inside of a camera device including the CMOS image sensor 10. The computer 20 may be provided outside of the camera device.

A display device 26 and an input device 27 may be connected to the computer 20. The display device 26 is, for example, a display that can display a result of photon counting acquired by the computer 20. The input device 27 may be a keyboard, a mouse, or the like for allowing a user to input measurement conditions. The display device 26 and the input device 27 may be a touch screen. The display device 26 and the input device 27 may be included in the computer 20. The display device 26 and the input device 27 may be provided in the camera device including the CMOS image sensor 10.

The estimation unit 21 estimates a gain (a conversion factor) which is a ratio between the number of photoelectrons generated in a pixel in response to inputting light of a predetermined number of photons (a light intensity) to the pixel and a digital value (an electrical signal intensity) output according to the number of photoelectrons. Estimating of a gain by the estimation unit 21 may be performed, for example, in the course of manufacturing the photon counting device 1. Estimating of a gain by the estimation unit 21 may be performed, for example, at an arbitrary timing by a user of the photon counting device 1. Processing details of the estimation unit 21 will be described later.

The storage unit 22 stores data for converting a digital value output from the CMOS image sensor 10 to the number of photoelectrons. For example, the storage unit 22 stores a gain in each of the plurality of pixels 11 as a lookup table. The gain may be a value estimated by the estimation unit 21. The storage unit 22 may store reading noise in each of the plurality of pixels 11 as a lookup table.

A digital value [DN] output from the A/D converter 15 is expressed by the following formula when it is linear with respect to the number of photoelectrons.

[Formula 6]

$$\text{Digital value} = \text{gain} \times \text{number of photoelectrons}$$

As expressed by the formula, for example, it is assumed that a digital value does not include an offset value. When a digital value includes an offset value, the digital value is expressed by the following formula. Accordingly, when a digital value includes an offset value, a value obtained by subtracting the offset value from the output digital value is considered to be a digital value in this specification.

[Formula 7]

$$\text{Digital value} = \text{gain} \times \text{number of photoelectrons} + \text{offset value}$$

The offset value [DN] is expressed as a digital value which is output in a state in which light is not input. Therefore, the offset value is acquired by acquiring a plurality of digital values from a plurality of dark images acquired by the CMOS image sensor 10 in the state in which light is not input and averaging the acquired digital values for each pixel 11. When a digital value includes an offset value, the storage unit 22 may store the offset value for each of the plurality of pixels 11 acquired as described above as a lookup table.

The conversion unit 23 converts the digital value for each of the plurality of pixels 11 output from the A/D converter 15 to the number of photoelectrons with reference to a table stored in the storage unit 22. The conversion unit 23 may derive the number of photoelectrons for each pixel 11 by dividing the digital value by the gain as expressed by the following formula. When a digital value includes an offset value, the number of photoelectrons may be derived by dividing a value obtained by subtracting the offset value from the measured digital value by the gain.

[Formula 8]

$$\text{Number of photoelectrons} = \text{digital value} / \text{gain}$$

The conversion unit 23 may acquire the number of photoelectrons which is expressed as an integer by truncating a fractional part of the derived number of photoelectrons to round off the number of photoelectrons. In this case, the number of photoelectrons which is expressed as an integer may be acquired by setting a predetermined threshold value range for the number of photoelectrons derived by the aforementioned formula. For example, the threshold value range corresponding to 5 photoelectrons is equal to or greater than 4.5 e and less than 5.5 e. For example, the conversion unit 23 can acquire the number of photons by dividing the number of photoelectrons for each pixel 11 by quantum efficiency. When the quantum efficiency is 100%, the number of photoelectrons and the number of photons are the same. For the purpose of convenience, the conversion unit 23 derives the number of photoelectrons, but the number of photoelectrons may be replaced with the number of photons.

The data processing unit 24 prepares a two-dimensional image (a photoelectron number resolving image) indicating the number of photoelectrons in each pixel 11 based on the number of photoelectrons output from the conversion unit 23. For example, the two-dimensional image may be an image in which pixels are displayed in luminance corresponding to the number of photoelectrons. The prepared two-dimensional image can be output to the display device 26. The data processing unit 24 may prepare a histogram or the like which is a plot of the number of pixels with respect to the number of photoelectrons. The control unit 25 can comprehensively control the functional units of the computer 20 or the CMOS image sensor 10.

The estimation unit 21 will be described below in detail. The estimation unit 21 according to an example includes an acquisition unit 21a and a calculation unit 21b. The acquisition unit 21a performs an acquisition process of acquiring a plurality of data groups including a digital value of each of the plurality of pixels 11 when light is input to each of the plurality of pixels 11. A data group may be acquired, for example, as image data (an optical image) in which the pixels 11 and digital values are correlated. The acquisition unit 21a acquires a plurality of frames of image data. The acquisition unit 21a acquires a plurality of digital values corresponding to each pixel 11 based on the acquired frames of image data.

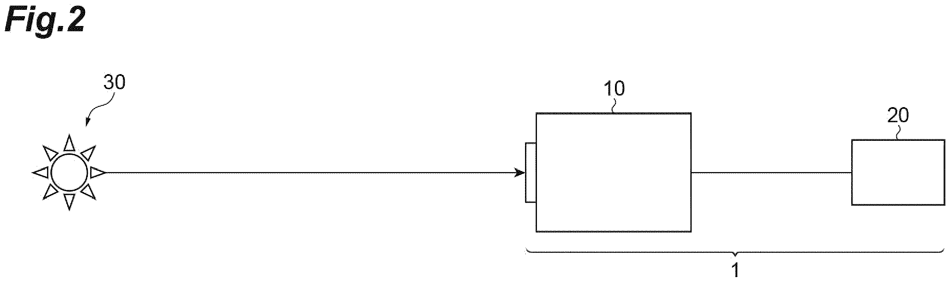

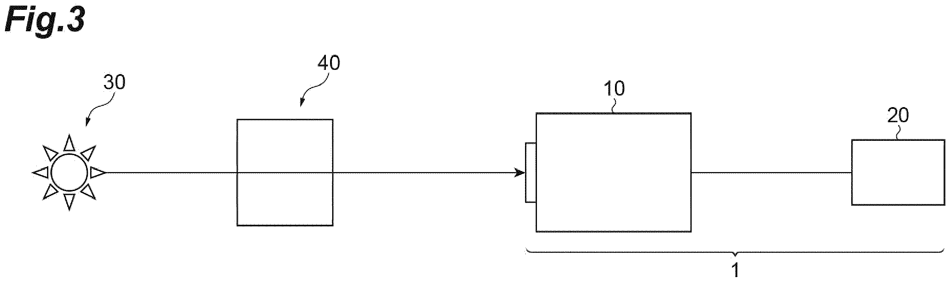

FIGS. 2 and 3 are diagrams illustrating a usage mode of the photon counting device according to the example. For example, as illustrated in FIG. 2, the photon counting device 1 may acquire image data in a state in which light output from a light source 30 is input to the CMOS image sensor 10. As illustrated in FIG. 3, an object 40 such as an observation sample may be provided on an optical path between the light source 30 and the CMOS image sensor 10. That is, the acquisition unit 21a may acquire image data obtained by imaging the object 40.

The calculation unit 21b performs a calculation process of calculating a gain for each of the plurality of pixels 11 from the plurality of data groups based on a likelihood function associated with a gain. The likelihood function associated with a gain is a function indicating a likelihood of the gain corresponding to a plurality of digital values output for each pixel 11.

The likelihood function is defined with reference to a probability density distribution (a probability model) of digital values. Electrical characteristics in the CMOS image sensor 10 may be reflected in the probability density distribution of digital values. Characteristics of light input to the CMOS image sensor 10 may be reflected in the probability density distribution of digital values. For example, when a probability distribution of the number of photoelectrons n [e] is defined as $q(n)$, a function of determining a digital value $x$ [DN] in response to the number of photoelectrons n when the gain is $\alpha$ is defined as $x = f(n; \alpha)$, and a probability density distribution of a digital value $x_i$ in the i-th data group at the number of photoelectrons n is defined as $r(x_i; n, \alpha, [f])$, the likelihood function $L(\alpha)$ is expressed by the following formula which is a general formula. [f] means that r is defined using a function f.

[Formula 9]

$$L\left(\alpha\right) = \prod_{i}\sum_{n} q(n)r(x_i; n, \alpha, [f])$$

When the average photon number of radiated light changes with the elapse of time and a probability distribution of the number of photoelectrons n [e] is $q_i(n)$, the gain $\alpha$ [DN/e] can be accurately estimated based on a likelihood function $L(\alpha)$ expressed by the following formula. In the following formula, when the probability distribution $q_i(n)$ of the number of photoelectrons n [e] is replaced with q(n) regardless of i, the likelihood function $L(\alpha)$ is expressed by the aforementioned formula ([Formula 9]) in which the average photon number of radiated light is fixed.

[Formula 10]

$$L\left(\alpha\right) = \prod_{i}\sum_{n} q_i(n)r(x_i; n, \alpha, [f])$$

For example, the probability density distribution of digital values may be a convolution (a composition product) of a probability density distribution of digital values in consideration of reading noise of the amplifier 13 in each pixel 11 and a probability distribution of the number of photoelectrons n, where the number of photoelectrons is n. For example, the average photon number is defined as $\lambda$ [photon], the probability distribution q(n) is defined as a Poisson distribution of the average photon number $\lambda$, reading noise is defined as $\sigma$ [e-rms], a function f(n; $\alpha$) is defined as f(n; $\alpha$)= $\alpha$n which is a linear function, and a probability density distribution r(x;; n, $\alpha$, [f]) is a normal distribution with an average of f(n; $\alpha$) and a standard deviation of $\sigma$, the likelihood function $L(\alpha)$ is expressed by the following formula.

[Formula 11]

$$L\left(\alpha\right) = \prod_{i}\sum_{n} \frac{e^{-\lambda}\lambda^n}{n!} \exp\left\{-\frac{(x_i - \alpha n)^2}{2\sigma^2}\right\}$$

The calculation unit 21b calculates a most probable gain $\alpha$ from the likelihood function through so-called maximum likelihood estimation. For example, a gain $\alpha$ maximizing a logarithmic likelihood function derived from the likelihood function is calculated. An example of the logarithmic likelihood function is described below.

[Formula 12]

$$L\left(\alpha\right) = \sum_{i} \log\left[\sum_{n} \frac{e^{-\lambda}\lambda^n}{n!} \exp\left\{-\frac{(x_i - \alpha n)^2}{2\sigma^2}\right\}\right]$$

The reading noise $\sigma$ may be acquired using a known method. The reading noise can be defined as fluctuation of the gain. Therefore, a standard deviation of a digital value for each pixel 11 may be acquired in a plurality of (for example, 100 frames or more) dark images, and the acquired standard deviation may be used as the reading noise $\sigma$. The reading noise $\sigma$ does not have to be known with high accuracy.

When the average photon number $\lambda$ is a known value, the value may be used. Similarly to the reading noise $\sigma$, the average photon number $\lambda$ does not have to be known with high accuracy. Therefore, when the average photon number $\lambda$ is unknown, the calculation unit 21b may calculate the average photon number $\lambda$, for example, using an approximate value $\alpha'$ of the gain $\alpha$. For example, an average photon number $\lambda$ as an approximate value in N pixels in a predetermined range is calculated based on the following formula. The N pixels may be all the pixels. In the following formula, nonlinearity of digital values is not considered.

## [Formula 13]

$$\lambda = \frac{1}{N} \sum_i \frac{x_i}{\alpha'}$$

When the average photon number $\lambda$ is unknown, the average photon number may be defined by the following formula.

## [Formula 14]

$$\lambda(\alpha) = \frac{1}{N} \sum_i \frac{x_i}{\alpha}$$

In this case, the calculation unit 21b may calculate the gain $\alpha$ for maximizing a logarithmic likelihood function expressed by the following formula.

## [Formula 15]

$$L(\alpha) = \sum_i \log \left[ \sum_n \frac{e^{-\lambda(\alpha)} \lambda(\alpha)^n}{n!} \exp\left\{ -\frac{(x_i - \alpha n)^2}{2\sigma^2} \right\} \right]$$

For example, when an approximate value $\alpha'$ of the gain $\alpha$ is acquired, an average value of digital values of a target pixel and a variance of the digital values in the frames with the same average photon number may be calculated, plotting may be performed with the average value on the horizontal axis and with the variance on the vertical axis, and a reciprocal of a slope of an approximate straight line may be used as the approximate value $\alpha'$. When measurement is performed without changing a light intensity, a value obtained by dividing the variance of the digital values by the average value of the digital values may be used as the approximate value $\alpha'$. The approximate value $\alpha'$ of the gain in each pixel 11 acquired in this way may be stored in the storage unit 22.

When the gain $\alpha$ is estimated based on the logarithmic likelihood function, the logarithmic likelihood function for $\alpha$ can be maximized. When the approximate value $\alpha'$ of the gain $\alpha$ is acquired, the calculation unit 21b may maximize the logarithmic likelihood function using a gradient method such as a Newton method using $\alpha'$ as an initial value. When the likelihood function has a local optimal solution and the approximate value $\alpha'$ of the gain $\alpha$ is not acquired, the gradient method cannot be used. In this case, it is necessary to comprehensively search for $\alpha$ maximizing the logarithmic likelihood function in a predetermined range. The calculation unit 21b may estimate the gain $\alpha$ of all the pixels by performing such a process for each pixel 11. The estimated gain $\alpha$ for each pixel 11 is stored in the storage unit 22 in correlation with the corresponding pixel 11. The number of photoelectrons is estimated by the conversion unit 23 with reference to the estimated gain $\alpha$.

When the process of estimating the gain $\alpha$ is performed, for example, on several thousands $\times$ several thousands of pixels, a calculation load thereof is enormous. For example, the calculation unit 21b fast performs estimation of the gain $\alpha$ by performing parallel calculation. For example, when 10 search points are searched for 10 pixels, fast processing can be achieved by evaluating a j-th search point of an i-th pixel in a (i+j $\times$ 10)-th thread.

The aforementioned likelihood function is an example. In the process of estimating the gain $\alpha$ which is performed by the estimation unit 21, another likelihood function may be used. For example, a likelihood function may be expressed by the following formula with the probability distribution q(n) of the number of photoelectrons fixed.

## [Formula 16]

$$L(\alpha) = \prod_i \sum_n \exp\left\{ -\frac{(x_i - \alpha n)^2}{2\sigma^2} \right\}$$

When the probability density distribution r(x;; n, $\alpha$, [f]) is expressed by the formula of [Formula 18] using a t-distribution of a degree of freedom v expressed by the formula of [Formula 17], the likelihood function may be expressed by the formula of [Formula 19], where the probability distribution q(n) is a Poisson distribution of the average photon number $\lambda$ and the function f(n; $\alpha$) is $\alpha$n which is a linear function.

[Formula 17]

$$v = \frac{2\sigma^2}{\sigma^2 - 1}$$

[Formula 18]

$$r(x; n, \boldsymbol{\alpha}, [f]) = \frac{\Gamma\left(\frac{v+1}{2}\right)}{\sqrt{v\pi}\,\Gamma\left(\frac{v}{2}\right)}\left\{1 + \frac{(x - \alpha n)^2}{v}\right\}^{-(v+1)/2}$$

[Formula 19]

$$L\left(\alpha\right) = \prod_i \sum_n \frac{e^{-\lambda}\lambda^n}{n!}\frac{\Gamma\left(\frac{v+1}{2}\right)}{\sqrt{v\pi}\,\Gamma\left(\frac{v}{2}\right)}\left\{1 + \frac{(x - \alpha n)^2}{v}\right\}^{-(v+1)/2}$$

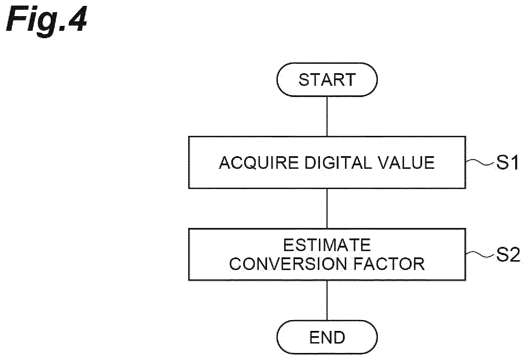

FIG. 4 is a flowchart illustrating an example of a process of estimating a gain $\alpha$ which is performed by the estimation unit 21. As illustrated in FIG. 4, the estimation unit 21 acquires a digital value (Step S1). That is, the estimation unit 21 acquires a plurality of data groups including digital values for each of a plurality of pixels 11 when light is input to the plurality of pixels 11. For example, the estimation unit 21 acquires a plurality of pieces of image data indicating a light intensity distribution in which each pixel 11 and the digital values are correlated in a state in which light is radiated from the light source 30. For example, the number of pieces of image data acquired by the estimation unit 21 may be about 100 to 1000 frames. The light intensity distribution formed by the light source 30 may be uniform spatially and temporally or may not be uniform.

Subsequently, the estimation unit 21 estimates a gain $\alpha$ which is a conversion factor (Step S2). That is, the estimation unit 21 calculates the gain $\alpha$ for each of the plurality of pixels 11 from digital values of the plurality of pieces of image data based on the likelihood function indicating the likelihood of the gain $\alpha$ corresponding to the output digital value. When light radiated from the light source 30 can be controlled, the average photon number $\lambda$ may be designated based on information of controlled light. The estimation unit 21 stores the estimated gains of all the pixels in the storage unit 22.

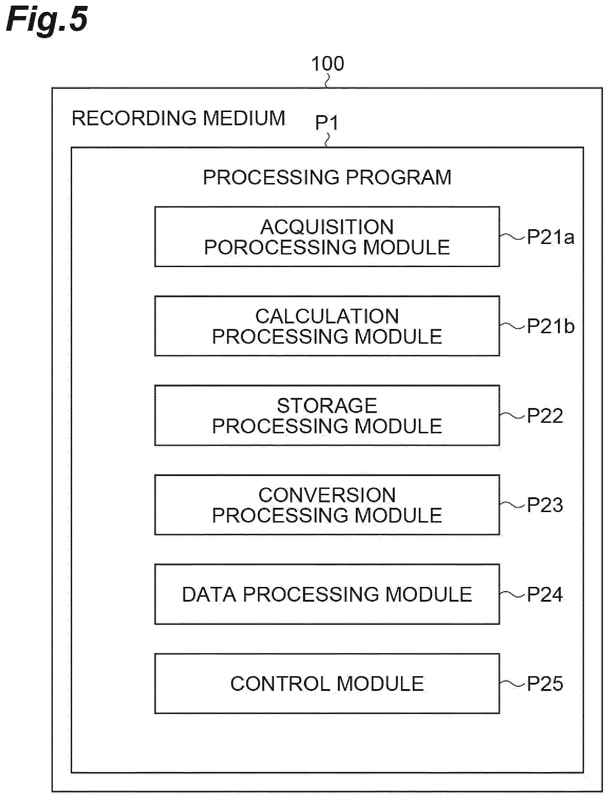

FIG. 5 is a block diagram illustrating a recording medium 100 in which a processing program P1 (an estimation program) causing a computer to perform a photon counting process including the process of estimating a gain $\alpha$ is stored. The processing program P1 stored in the recording medium 100 includes an acquisition processing module P21a, a calculation processing module P21b, a storage processing module P22, a conversion processing module P23, a data processing module P24, and a control module P25. Functions which are realized by executing the acquisition processing module P21a, the calculation processing module P21b, the storage processing module P22, the conversion processing module P23, the data processing module P24, and the control module P25 are the same as the functions of the acquisition unit 21a, the calculation unit 21b, the storage unit 22, the conversion unit 23, the data processing unit 24, and the control unit 25.

The processing program P1 is recorded in a program recording area in a computer-readable recording medium 100. The recording medium 100 may be a non-transitory recording medium. The recording medium 100 is constituted, for example, by a recording medium such as a CD-ROM, a DVD, a ROM, or a semiconductor memory. The processing program P1 may be provided as computer data signals superimposed on carrier waves via a communication network.

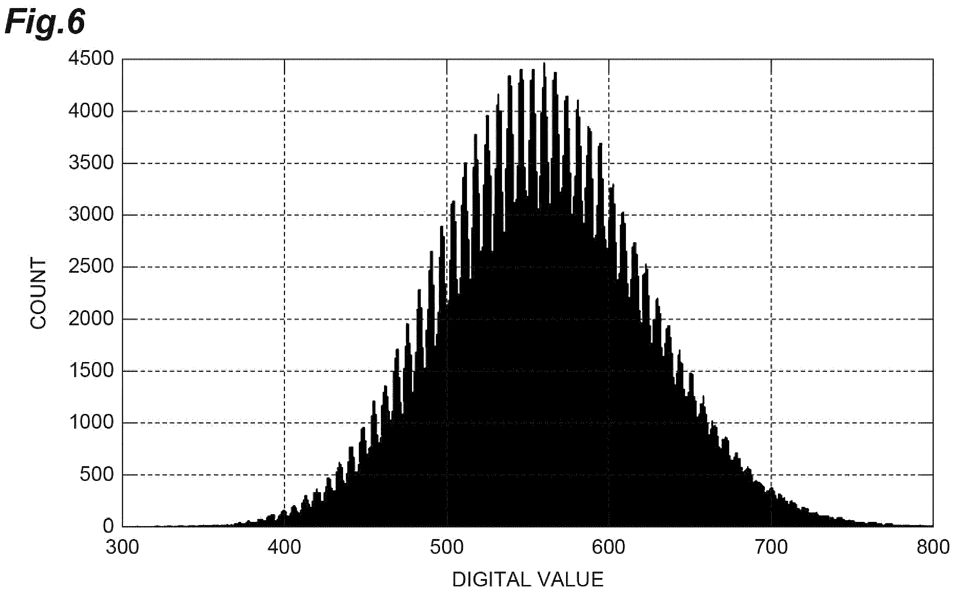

FIG. 6 is a diagram illustrating simulation results of digital values derived by the photon counting device according to the example in a histogram. The vertical axis represents a digital value, and the vertical axis represents a count. In FIG. 6, the average photon number $\lambda$ is 80. An average of the gain $\alpha$ is 7 [DN/e]. A standard deviation of the gain $\alpha$ is 0.02. The reading noise $\sigma$ is 1.8 [DN]. The value of the reading noise corresponds to the number of photoelectrons and is about 0.26 [e-rms]. The number of pixels is 32×32. The number of frames of the acquired image data (data groups) is 1000. As illustrated in FIG. 6, in the histogram of digital values, a resolution of peaks (of summits and valleys) becomes unclear as the digital value becomes larger.

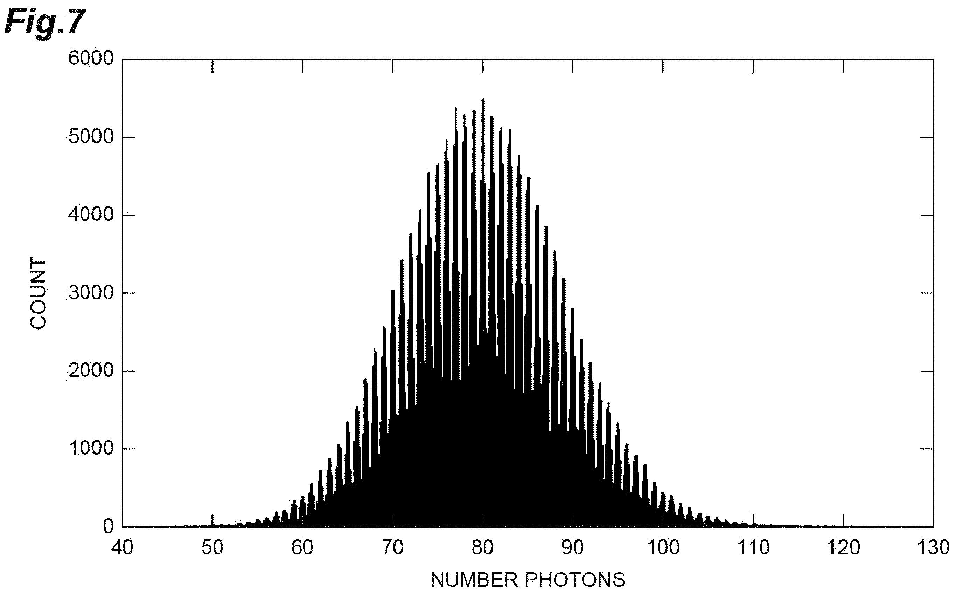

FIG. 7 is a diagram illustrating effectiveness of the gains estimated based on the digital values in the example illustrated in FIG. 6. In FIG. 7, the digital values are converted to the number of photons based on the gains estimated using the aforementioned method, and a histogram of the converted number of photons is illustrated. The horizontal axis represents the number of photons, and the vertical axis represents a count. In the histogram of the number of photons illustrated in FIG. 7, it can be seen that a resolution of peaks is clearer than that in the histogram of the digital values illustrated in FIG. 6. The likelihood function used to estimate the gains in the example illustrated in FIG. 7 is expressed by the following formula.

[Formula 20]

$$L(\alpha) = \sum_i \log \left[ \sum_n \frac{e^{-\lambda}\lambda^n}{n!} \exp\left\{ -\frac{(x_i - \alpha n)^2}{2\sigma^2} \right\} \right]$$

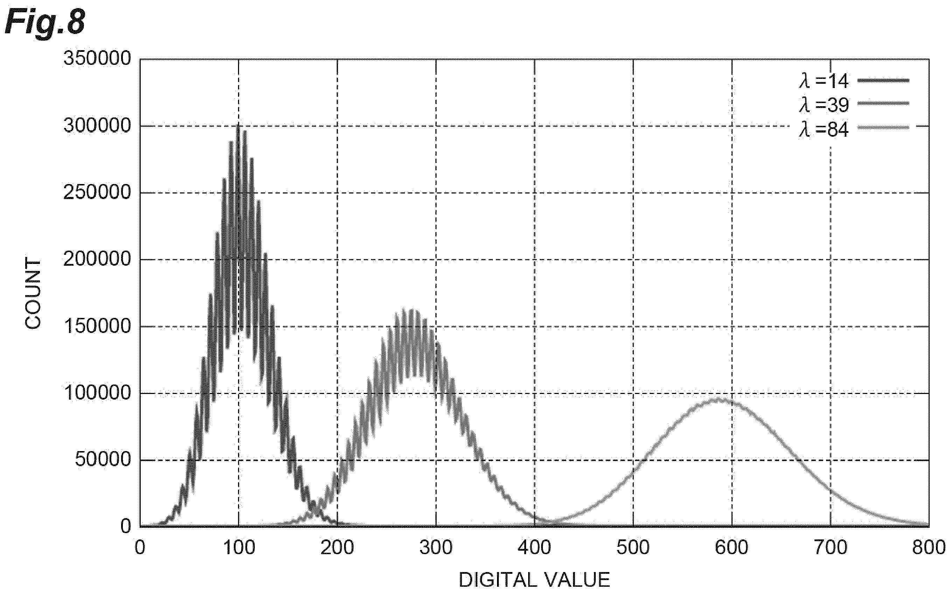

FIG. 8 is a diagram illustrating measured values of the digital values derived by the photon counting device according to the example in a histogram. The vertical axis represents a digital value, and the vertical axis represents a count. In FIG. 8, three patterns in which the average photon number $\lambda$ is 14, 39, and 84 are illustrated. The number of pixels is 1630×1630. The number of frames of the acquired image data (data groups) is 1000. In the histogram of digital values illustrated in FIG. 8, a resolution of peaks becomes unclear as the digital value becomes larger. In addition, the resolution of peaks becomes unclear as the average photon number $\lambda$ becomes larger.

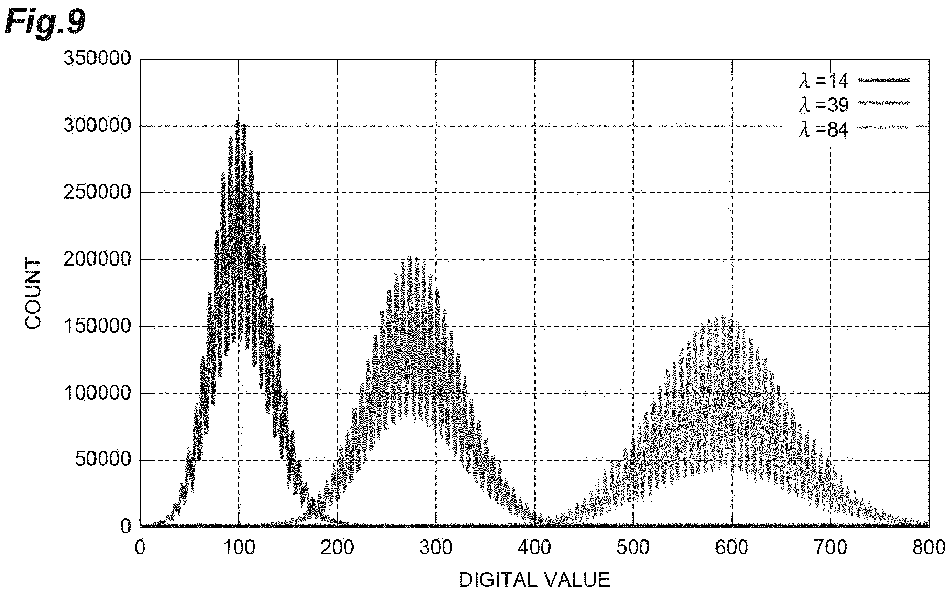

FIG. 9 is a diagram illustrating effectiveness of the gain estimated based on the digital values in the example illustrated in FIG. 8. In FIG. 9, a digital value is converted to the number of photoelectrons based on the gain $\alpha$ estimated using the aforementioned method, and the converted number of photoelectrons is converted to a digital value using the average value of the gains $\alpha$ again. FIG. 9 illustrates a histogram of reconverted digital values. The vertical axis represents a reconverted digital value, and the vertical axis represents a count. The gains $\alpha$ have been estimated using the aforementioned method based on the image data acquired when the average photon number $\lambda$ is 84. The gains $\alpha$ have been used to reconvert three histograms in which the average photon number $\lambda$ is 14, 39, and 84. In the histogram of the reconverted digital values illustrated in FIG. 9, it can be seen that a resolution of peaks is clearer than that in the histogram of the digital values illustrated in FIG. 8.

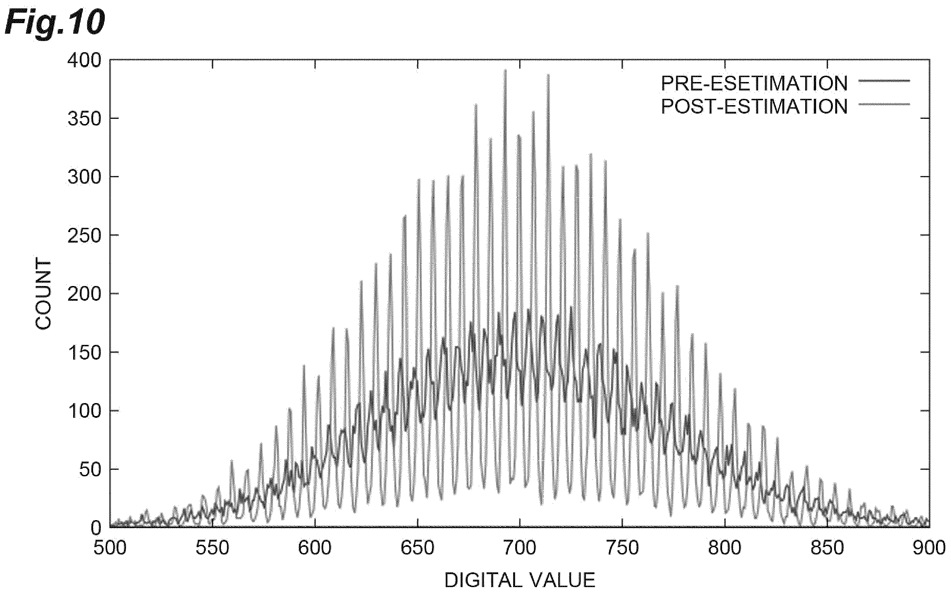

FIG. 10 illustrates a histogram (pre-estimation) of simulation results of digital values derived by the photon counting device and a histogram (post-estimation) of reconverted digital values. The reconverted digital values are values obtained by converting original digital values to the number of photoelectrons based on the gains $\alpha$ estimated using the aforementioned method and then reconverting the converted number of photoelectrons to a digital value using the average value of the gains $\alpha$. The vertical axis represents a digital value, and the vertical axis represents a count. The average photon number $\lambda$ is 100. The average of the gains $\alpha$ is 7 [DN/e]. The standard deviation of the gains $\alpha$ is 0.05. The reading noise $\sigma$ is 0.25×gain. That is, when the average of the gains $\alpha$ is 7 [DN/e], the average of the reading noise $\sigma$ is 1.75 [DN]. The number of pixels is 32×32. The number of frames of the acquired image data (data groups) is 500. The likelihood function used to estimate the gain in the example illustrated in FIG. 10 is expressed by the following formula.

[Formula 21]

$$L(\alpha) = \prod_i \sum_n \frac{e^{-\lambda}\lambda^n}{n!} \frac{\Gamma\left(\frac{\nu+1}{2}\right)}{\sqrt{\nu\pi}\Gamma\left(\frac{\nu}{2}\right)} \left\{ 1 + \frac{(x - \alpha n)^2}{\nu} \right\}^{-(\nu+1)/2}$$

As illustrated in FIG. 10, it can be seen that a resolution of peaks in the reconverted histogram is clearer than that in the histogram of the original digital values. In this way, the likelihood function used for the estimation method can be defined with reference to various models as long as it is based on a probability model of output digital values.

As described above, the photon counting device 1 which is an estimation device according to an example includes an acquisition unit 21a configured to acquire a plurality of digital values of each pixel 11 when light is input the pixel 11 and a calculation unit 21b configured to calculate a gain of each pixel from a plurality of pieces of data based on a likelihood function indicating a likelihood of the gain corresponding to the output digital values.

In the photon counting device 1, since a likelihood function is used to estimate a gain, it is possible to reduce an amount of data required for estimating the gain. For example, when the data is image data in which a digital value in each pixel is reflected, it is possible to reduce the number of frames required for estimating the gain.

The likelihood function may be defined with reference to a probability density distribution of digital values. The probability density distribution of the digital values may include a probability distribution $q(n)$ of the number of photoelectrons n and a probability density distribution $r(x;; n, \alpha, [f])$ of the digital values when the number of photoelectrons is n. In this likelihood function, since the probability distribution of the number of photoelectrons and the probability density distribution of the digital values when the number of photoelectrons is determined, it is possible to estimate the gain with high accuracy.

The probability density distribution of the digital values may include a probability density distribution in consideration of reading noise of the amplifiers 13 in the plurality of pixels 11. It is possible to improve accuracy of the probability density distribution by considering the reading noise.

The probability distribution $q(n)$ of the number of photoelectrons n may be constant. In this case, even when a light intensity fluctuates during measurement, it is possible to relax an influence of the fluctuation of a light intensity on estimation of a gain.

While an embodiment has been described above in detail with reference to the drawings, a specific configuration is not limited to the embodiment.

While some probability density distributions of digital values have been described above, the probability density distribution does not have to be actually accurate. For example, a symmetric distribution may be employed for an originally asymmetric distribution, an approximate distribution different from an original distribution of a physical phenomenon may be employed, or a distribution which cannot be strictly omitted may be omitted.

An example in which the function $f(n; \alpha)$ which is an example of the likelihood function is a linear function $f(n; \alpha)= \alpha n$ has been described above, but, for example, when the digital value [DN] is nonlinear with respect to the number of photoelectrons, the function $f(n; \alpha)$ may be a quadratic function such as $f(n; \alpha)= \alpha_0 n + \alpha_1 n^2$, or may be a cubic or higher function. In this way, when the digital value [DN] is nonlinear with respect to the number of photoelectrons, the number of photoelectrons n can be calculated from a reciprocal function $n = f^{-1}(x; \alpha)$ of the function $x = f(n; \alpha)$ for determining the digital value x [DN] with respect to the number of photoelectrons n when the gain is $\alpha$ [DN/e]. In this case, the average photon number $\lambda$ can be calculated by the following formula.

[Formula 22]

$$\lambda = \frac{1}{N} \sum_i f^{-1}(x_i; \alpha')$$

In the aforementioned embodiment, a dark count is not considered, but when the dark count is significantly large, a sum of a true average photon number and an average counted number of the dark count may be used as the average photon number.

**Reference Signs List**

1       Photon counting device
11      Pixel
21      Estimation unit
21a     Acquisition unit
21b     Calculation unit

**Claims**

**1.** An estimation method of estimating a conversion factor which is a ratio between the number of photoelectrons generated from a pixel in response to inputting of light to the pixel and an electrical signal intensity output in response to the number of photoelectrons, the estimation method comprising:

a step of acquiring a plurality of data groups including the electrical signal intensity for each of a plurality of pixels when light is input to the plurality of pixels; and

a step of calculating the conversion factor for each of the plurality of pixels from the plurality of data groups based on a likelihood function indicating a likelihood of the conversion factor corresponding to the output electrical signal intensity.

2. The estimation method according to claim 1, wherein the likelihood function is defined with reference to a probability density distribution of the electrical signal intensities.

3. The estimation method according to claim 2, wherein the probability density distribution of the electrical signal intensities includes a probability density distribution in consideration of reading noise in the plurality of pixels.

4. The estimation method according to claim 2 or 3, wherein the probability density distribution of the electrical signal intensities includes a probability distribution of the number of photoelectrons.

5. The estimation method according to any one of claims 1 to 4, wherein, when a probability distribution of the number of photoelectrons n is defined as $q_i(n)$, a function of determining an electrical signal intensity x in response to the number of photoelectrons n when the conversion factor is $\alpha$ is defined as $x=f(n; \alpha)$, and a probability density distribution of an electrical signal intensity $x_i$ in the i-th data group at the number of photoelectrons n is defined as $r(x_i; n, \alpha, [f])$, $L(\alpha)$ which is the likelihood function is expressed by:

[Formula 1]

$$L(\alpha) = \prod_i \sum_n q_i(n) r(x_i; n, \alpha, [f])$$

6. The estimation method according to claim 5, wherein, when an average photon number is defined as $\lambda$ and reading noise is defined as $\sigma$, the likelihood function is expressed by:

[Formula 2]

$$L(\alpha) = \prod_i \sum_n \frac{e^{-\lambda}\lambda^n}{n!} \exp\left\{-\frac{(x_i - \alpha n)^2}{2\sigma^2}\right\}$$

7. The estimation method according to claim 5, wherein, when reading noise is defined as $\sigma$, the likelihood function is expressed by:

[Formula 3]

$$L(\alpha) = \prod_i \sum_n \exp\left\{-\frac{(x_i - \alpha n)^2}{2\sigma^2}\right\}$$

8. The estimation method according to claim 5, wherein, when a degree of freedom v is defined as:

[Formula 4]

$$v = \frac{2\sigma^2}{\sigma^2 - 1}$$

,

$r(x_i; n, \alpha, [f])$ indicating the probability density distribution is defined using a t-distribution of the degree of freedom v, and
wherein the likelihood function is expressed by:

[Formula 5]

$$L(\alpha) = \prod_i \sum_n \frac{e^{-\lambda}\lambda^n}{n!} \frac{\Gamma\left(\frac{v+1}{2}\right)}{\sqrt{v\pi}\,\Gamma\left(\frac{v}{2}\right)} \left\{1 + \frac{(x-\alpha n)^2}{v}\right\}^{-(v+1)/2}$$

9. An estimation program for estimating a conversion factor which is a ratio between the number of photoelectrons generated from a pixel in response to inputting of light to the pixel and an electrical signal intensity output in response to the number of photoelectrons, the estimation program causing a computer to perform:

an acquisition process of acquiring a plurality of data groups including the electrical signal intensity for each of a plurality of pixels when light is input to the plurality of pixels; and
a calculation process of calculating the conversion factor for each of the plurality of pixels from the plurality of data groups based on a likelihood function indicating a likelihood of the conversion factor corresponding to the output electrical signal intensity.

10. The estimation program according to claim 9, wherein the likelihood function is defined with reference to a probability density distribution of the electrical signal intensities.

11. The estimation program according to claim 10, wherein the probability density distribution of the electrical signal intensities includes a probability density distribution in consideration of reading noise in the plurality of pixels.

12. The estimation program according to claim 10 or 11, wherein the probability density distribution of the electrical signal intensities includes a probability distribution of the number of photoelectrons.

13. The estimation program according to any one of claims 9 to 12, wherein, when a probability distribution of the number of photoelectrons n is defined as $q_i(n)$, a function of determining an electrical signal intensity x in response to the number of photoelectrons n when the conversion factor is $\alpha$ is defined as x=f(n; $\alpha$), and a probability density distribution of an electrical signal intensity $x_i$ in the i-th data group at the number of photoelectrons n is defined as r(x;; n, $\alpha$, [f]), L($\alpha$) which is the likelihood function is expressed by:

[Formula 6]

$$L(\alpha) = \prod_i \sum_n q_i(n) r(x_i; n, \alpha, [f])$$

14. The estimation program according to claim 13, wherein, when an average photon number is defined as $\lambda$ and reading noise is defined as $\sigma$, the likelihood function is expressed by:

[Formula 7]

$$L(\alpha) = \prod_i \sum_n \frac{e^{-\lambda}\lambda^n}{n!} \exp\left\{-\frac{(x_i-\alpha n)^2}{2\sigma^2}\right\}$$

15. The estimation program according to claim 13, wherein, when an average photon number is defined as $\lambda$ and reading noise is defined as $\sigma$, the likelihood function is expressed by:

[Formula 8]

$$L(\alpha) = \sum_i \log\left[\sum_n \frac{e^{-\lambda(\alpha)}\lambda(\alpha)^n}{n!}\exp\left\{-\frac{(x_i - \alpha n)^2}{2\sigma^2}\right\}\right]$$

16. The estimation program according to claim 13, wherein, when reading noise is defined as $\sigma$, the likelihood function is expressed by:

[Formula 9]

$$L(\alpha) = \prod_i \sum_n \exp\left\{-\frac{(x_i - \alpha n)^2}{2\sigma^2}\right\}$$

17. The estimation program according to claim 13, wherein, when a degree of freedom $v$ is defined as:

[Formula 10]

$$v = \frac{2\sigma^2}{\sigma^2 - 1}$$

,

r(x;; n, $\alpha$, [f]) indicating the probability density distribution is defined using a t-distribution of the degree of freedom v, and
wherein the likelihood function is expressed by:

[Formula 11]

$$L(\alpha) = \prod_i \sum_n \frac{e^{-\lambda}\lambda^n}{n!} \frac{\Gamma\left(\frac{v+1}{2}\right)}{\sqrt{v\pi}\,\Gamma\left(\frac{v}{2}\right)}\left\{1 + \frac{(x - \alpha n)^2}{v}\right\}^{-(v+1)/2}$$

18. An estimation device for estimating a conversion factor which is a ratio between the number of photoelectrons generated from a pixel in response to inputting of light to the pixel and an electrical signal intensity output in response to the number of photoelectrons, the estimation device comprising:

an acquisition unit configured to acquire a plurality of data groups including the electrical signal intensity for each of a plurality of pixels when light is input to the plurality of pixels; and
a calculation unit configured to calculate the conversion factor for each of the plurality of pixels from the plurality of data groups based on a likelihood function indicating a likelihood of the conversion factor corresponding to the output electrical signal intensity.

19. The estimation device according to claim 18, wherein the likelihood function is defined with reference to a probability density distribution of the electrical signal intensities.

20. The estimation device according to claim 19, wherein the probability density distribution of the electrical signal intensities includes a probability density distribution in consideration of reading noise in the plurality of pixels.

21. The estimation device according to claim 19 or 20, wherein the probability density distribution of the electrical signal intensities includes a probability distribution of the number of photoelectrons.

22. The estimation device according to any one of claims 18 to 21, wherein, when a probability distribution of the number of photoelectrons n is defined as $q_i(n)$, a function of determining an electrical signal intensity x in response to the number of photoelectrons n when the conversion factor is $\alpha$ is defined as $x=f(n; \alpha)$, and a probability density distribution of an electrical signal intensity $x_i$ in the i-th data group at the number of photoelectrons n is defined as $r(x;; n, \alpha, [f])$, $L(\alpha)$ which is the likelihood function is expressed by:

[Formula 12]

$$L(\alpha) = \prod_i \sum_n q_i(n) r(x_i; n, \alpha, [f])$$

23. The estimation device according to claim 22, wherein, when an average photon number is defined as $\lambda$ and reading noise is defined as $\sigma$, the likelihood function is expressed by:

[Formula 13]

$$L(\alpha) = \prod_i \sum_n \frac{e^{-\lambda} \lambda^n}{n!} \exp\left\{-\frac{(x_i - \alpha n)^2}{2\sigma^2}\right\}$$

24. The estimation device according to claim 22, wherein, when an average photon number is defined as $\lambda$ and reading noise is defined as $\sigma$, the likelihood function is expressed by:

[Formula 14]

$$L(\alpha) = \sum_i \log\left[\sum_n \frac{e^{-\lambda(\alpha)} \lambda(\alpha)^n}{n!} \exp\left\{-\frac{(x_i - \alpha n)^2}{2\sigma^2}\right\}\right]$$

25. The estimation device according to claim 22, wherein, when reading noise is defined as $\sigma$, the likelihood function is expressed by:

[Formula 15]

$$L(\alpha) = \prod_i \sum_n \exp\left\{-\frac{(x_i - \alpha n)^2}{2\sigma^2}\right\}$$

26. The estimation device according to claim 22, wherein, when a degree of freedom v is defined as:

[Formula 16]

$$\nu = \frac{2\sigma^2}{\sigma^2 - 1}$$

,

$r(x_i; n, \alpha, [f])$ indicating the probability density distribution is defined using a t-distribution of the degree of freedom v, and
wherein the likelihood function is expressed by:

[Formula 17]

$$L(\alpha) = \prod_i \sum_n \frac{e^{-\lambda}\lambda^n}{n!} \frac{\Gamma\left(\frac{v+1}{2}\right)}{\sqrt{v\pi}\,\Gamma\left(\frac{v}{2}\right)}\left\{1 + \frac{(x-\alpha n)^2}{v}\right\}^{-(v+1)/2}$$

Fig.1

EP 4 358 533 A1

**Fig.2**

**Fig.3**

# Fig.4

```
        ┌─────────────┐
        │    START    │
        └─────────────┘
               │
   ┌───────────────────────────┐
   │   ACQUIRE DIGITAL VALUE    │──── S1
   └───────────────────────────┘
               │
   ┌───────────────────────────┐
   │         ESTIMATE          │
   │    CONVERSION FACTOR      │──── S2
   └───────────────────────────┘
               │
        ┌─────────────┐
        │     END     │
        └─────────────┘
```

## Fig.5

100

RECORDING MEDIUM    P1

PROCESSING PROGRAM

| ACQUISITION POROCESSING MODULE | ~P21a |

| CALCULATION PROCESSING MODULE | ~P21b |

| STORAGE PROCESSING MODULE | ~P22 |

| CONVERSION PROCESSING MODULE | ~P23 |

| DATA PROCESSING MODULE | ~P24 |

| CONTROL MODULE | ~P25 |

**Fig.6**

# Fig.7

# Fig.8

EP 4 358 533 A1

Fig.9

Fig.10

EP 4 358 533 A1

## INTERNATIONAL SEARCH REPORT

| International application No. |
|---|
| **PCT/JP2022/029355** |

**A. CLASSIFICATION OF SUBJECT MATTER**

*H04N 5/365*(2011.01)i; *G01J 1/02*(2006.01)i; *G01J 1/42*(2006.01)i
FI:  H04N5/365; G01J1/02 B; G01J1/42 H

According to International Patent Classification (IPC) or to both national classification and IPC

**B. FIELDS SEARCHED**

Minimum documentation searched (classification system followed by classification symbols)

H04N5/365; G01J1/02; G01J1/42

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2016-518747 A (YALE UNIVERSITY) 23 June 2016 (2016-06-23) paragraphs [0007]-[0114] | 1-4, 9-12, 18-21 |
| A | paragraphs [0007]-[0114] | 5-8, 13-17, 22-26 |
| Y | US 2011/0210262 A1 (RADIATION WATCH LIMITED) 01 September 2011 (2011-09-01) paragraph [0227] | 1-4, 9-12, 18-21 |
| Y | JP 2020-524422 A (PURDUE RESEARCH FOUNDATION) 13 August 2020 (2020-08-13) paragraphs [0008]-[0009], [0023]-[0025] | 1-4, 9-12, 18-21 |
| A | JP 2020-167728 A (HAMAMATSU PHOTONICS KK) 08 October 2020 (2020-10-08) paragraphs [0018]-[0051] | 1-26 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **16 August 2022** | **30 August 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/029355**

| Patent document cited in search report | | | Publication date (day/month/year) | Patent family member(s) | | | Publication date (day/month/year) |
|---|---|---|---|---|---|---|---|
| JP | 2016-518747 | A | 23 June 2016 | US | 2016/0044255 | A1 | |
| | | | | paragraphs [0009]-[0122] | | | |
| US | 2011/0210262 | A1 | 01 September 2011 | WO | 2007/144589 | A2 | |
| | | | | p. 62, lines 9-19 | | | |
| JP | 2020-524422 | A | 13 August 2020 | US | 2019/0385280 | A1 | |
| | | | | paragraphs [0008]-[0009], [0023]-[0025] | | | |
| JP | 2020-167728 | A | 08 October 2020 | US | 2020/0371261 | A1 | |
| | | | | paragraphs [0033]-[0072] | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019102636 A

- WO 2019102637 A

**Non-patent literature cited in the description**

- **STARKEY, DAKOTA A. ; ERIC R. FOSSUM.** Determining conversion gain and read noise using a photon-counting histogram method for deep sub-electron read noise image sensors. *IEEE Journal of the Electron Devices Society,* 2016, vol. 4 (3), 129-135